Europäisches Patentamt

European Patent Office

Office européen des brevets

(19)

(11) Publication number : **0 521 744 A2**

## (12) EUROPEAN PATENT APPLICATION

(21) Application number : **92401570.4**

(22) Date of filing : **05.06.92**

(51) Int. Cl.$^5$ : **G06F 11/10, H03M 13/12**

(30) Priority : **05.06.91 JP 134278/91**

(43) Date of publication of application :
**07.01.93 Bulletin 93/01**

(84) Designated Contracting States :
**DE FR GB**

(71) Applicant : **SONY CORPORATION**
**7-35, Kitashinagawa 6-chome Shinagawa-ku**
**Tokyo (JP)**

(72) Inventor : **Urakawa, Yoshiyuki**
**c/o Sony Corporation, 7-35, Kitashinagawa**
**6-chome**
**Shinagawa-ku, Tokyo (JP)**

(74) Representative : **Thévenet, Jean-Bruno et al**
**Cabinet BEAU DE LOMENIE 55 rue**
**d'Amsterdam**
**F-75008 Paris (FR)**

(54) **Maximum likelihood decoder.**

(57)   A maximum likelihood decoder utilizing a Viterbi algorithm for keeping a digital signal recording and/or reproducing system (1,2) from inter symbol interference. The maximum likelihood decoder has substitute states substituted for a plurality of states where the probability that inter symbol interference occurs is small or substitute transition paths substituted for a plurality of transition paths.

FIG.1

EP 0 521 744 A2

## BACKGROUND OF THE INVENTION

This invention relates to a maximum likelihood decoder for use in a digital magnetic recording and/or reproducing system and, more particularly, to a reduction in the circuit scale of the maximum likelihood decoder utilizing Viterbi algorithm to remove inter symbol interference.

Upon decoding the digital signal recorded on a recording medium, such as a magnetic recording medium or an optical recording medium, during a magnetic recording operation, the influence of the adjacent bits on the detection bit in the reproduced signal, that is, the inter symbol interference increases as the recorded wave length decreases. As well known in the art, the inter symbol interference is caused by a linear distortion or a nonlinear distortion. It is the current practice to remove the inter symbol interference resulting from a linear distortion by employing a linear equalizer including an integrator and a low path filter. With such a linear equalizer, however, noises are emphasized to reduce the signal-to-noise (S/N) ratio. In addition, the linear equalizer cannot remove the inter symbol interference resulting from a nonlinear distortion produced during a high-density digital magnetic recording operation. For this reason, a maximum likelihood decoder utilizing a viterbi algorithm has been proposed.

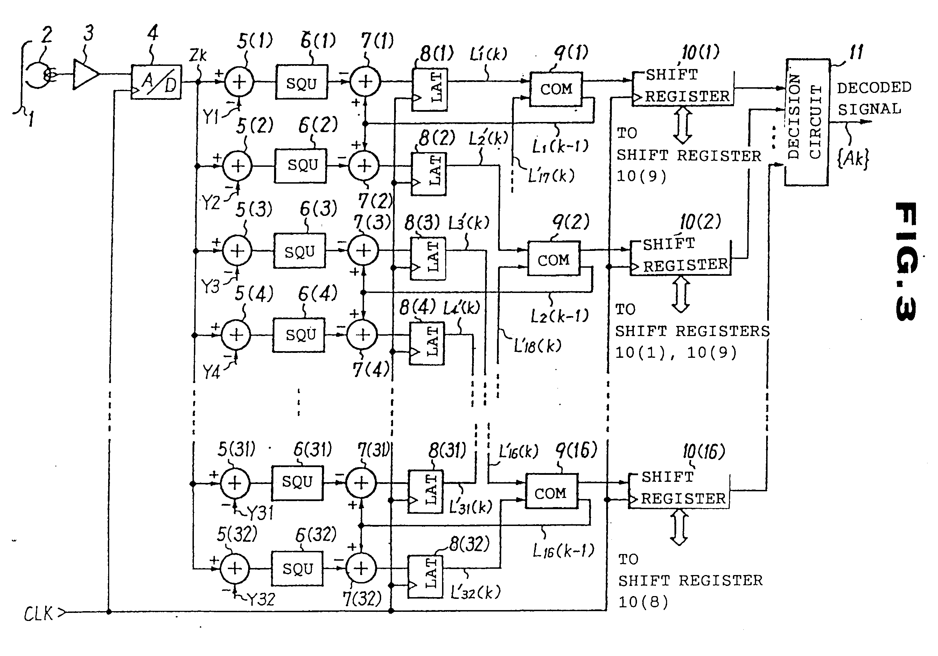

Fig. 3 shows one example of conventional maximum likelihood decoder having a 4-bit channel length. A head 2 is used to reproduce the magnetic record on a recording medium 1. The reproduced signal is amplified by a head amplifier 3. The amplified signal is sampled at uniform intervals of time in response to a clock (CLK) signal in an analog-to-digital (A/D) converter 4 to produce a sample sequence $\{Zk\}$ where k indicates a time. For the detection bit Ak, the number of the adjacent bits relating to the inter symbol interference, that is, the channel length may be set at a desired value. Fig. 3 shows the case where the channel length is 4 bits (2 front and rear bits). For 4-bit channel length, 16 combinations or states S of inter symbol interference exist.

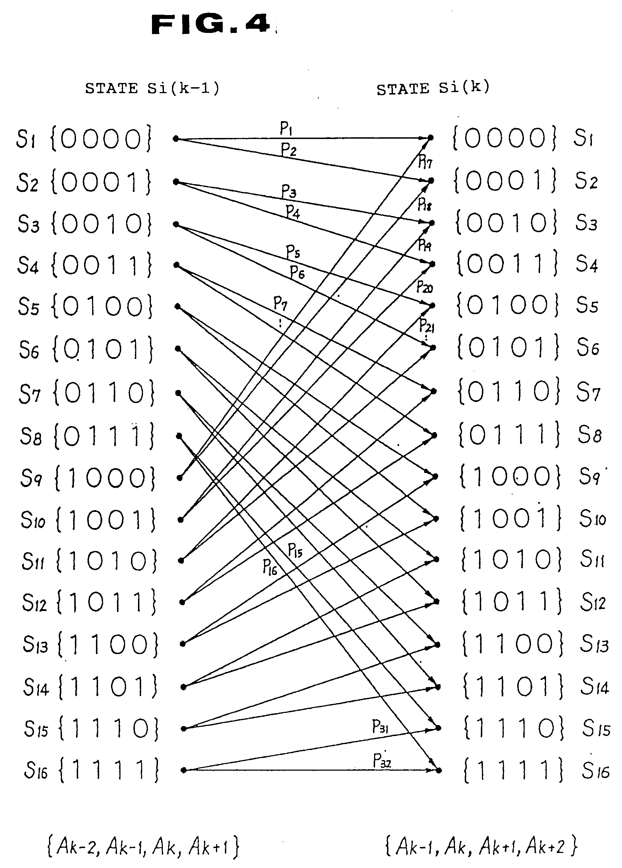

Fig. 4 is a Trellis diagram showing changes or transitions of states Si (where i = 1 to 16). A transition path Pj (where j = 2i - 1, 2i) extends from one state to another. Assuming now that yj is the estimated value for a sample Zk when the state transition is made through a transition path Pj, the sample Zk is expressed as Zk = yj + Nk where Nk is the Gaussian noise at time k. A proposed metric L'j, which is calculated from Equation (1), is used to select one of two transition paths Pi and Pi+16 extending to a state Si in Fig. 4. The selected transition path, that is, a surviving path, has a greater degree of likelihood.

$$L'j \ = \ Li \ (k - 1) \ - \ (Zk - Yj)^2 \quad (1)$$

where Li(k-1) is a metric for the state Si at time (k-1).

A comparison is made between the proposed metrics L'1 and L'i +16 of the respective transition paths Pi and Pi+16 joining to the state to select a surviving path. The selected surviving path has a greater proposed metric. The metric Li(k) for the state Si at time k is given by Equations (2) and (3) and is used in calculating a proposed metric at time (k+1).

$$Li(k) \ = \ L'i \text{ when } L'i > L'i + 16 \quad (2)$$
$$Li(k) \ = \ L'i + 16 \text{ when } L'i < L'i + 16 \quad (3)$$

The maximum likelihood decoding utilizes Viterbi algorithm to obtain a series of decoded signals $\{Ak\}$ having a maximum likelihood by repetitive operations of calculating a proposed metric L'j and selecting a surviving path from two transition paths joining to a state Si.

The conventional decoder shown in Fig. 3 performs maximum likelihood decoding process in the following manner:

First of all, the subtractor 5(j) and the squaring circuit 6(j) are used to calculate the transition length (Zk - Yi)² used in Equation (1). The subtractor 5(j) subtracts the transition length (Zk - Yj)² fed thereto from the squaring circuit 6(j) from the metric Li(k-1) at the last time (k-1) fed thereto from the comparator 9(j) to calculate a proposed metric L'j used in Equation (1). The proposed metric L'j is stored in the latch 8(j). The comparator 9(i) compares the two proposed metrics L'1 and L'i+16 and selects a larger one as the metric Li(k) at time k. The metric Li(k) is fed to the subtractor 7(j) for use in calculating a proposed metric L'j at time (k+1). The comparator 9(i) produces a one-bit code "0"or "1" to the shift register 10(i).

The operation of the shift register 10(i) is as follows:

The shift register 10(i) stores a series of binary codes corresponding to the respective surviving paths extending to the states Si. When a transition is made through the transition path Pi or Pi+16 to a state Si at time k, a comparison is made between the two proposed metric L'i and L'i+16 to determine a surviving path at time k. The binary code of the surviving path until time (k-1) is loaded in a parallel fashion on the shift register 10(i). For example, if L'1 > L'17 at time k, the content of the shift register 10(1) at time (k-1) will survive. If L'17 > L'1, the content of the shift register 10(9) will survive. That is, the content of the shift register 10(9) is loaded in a parallel fashion on the shift register 10(1). Similarly, the parallel load between shift registers are made for the other shift registers 10(2) to 10(16) based upon the Trellis diagram. Thereafter, a binary code "0" or "1" is fed from the comparator 9(i) to the shift register 10(i) based upon the results of the comparison made therein.

The content of the shift register 10(i) is shifted by one stage. That is, a binary code "0"is fed to the shift register 10(i) if $L'i > L'i+16$ from Trellis diagram, and a binary code "1" is fed to the shift register 10(i) if $L'i < L'i+16$. All of the binary codes outputted from the respective shift registers 10(i) will be the same if the shift register has a sufficient length. If different binary codes ("0"and "1") are mixed in the decoded codes in any of reasons, a series of decoded signals {Ak} is outputted through a decision circuit 11 which is arranged to make a decision under majority rule.

As can be seen from the arrangement of the conventional maximum likelihood decoder shown in Fig. 3, the number of the states Si is $i = 2^m$ and the number of the transition paths Pj is $j = 2_{m+1}$ where m is the inter symbol interference channel length. That is, the conventional maximum likelihood decoder is comprised of j subtractors 5, j subtractors 7, j squaring circuits 6, j latches 8 and i comparators 9 and i shift registers 10. As the record density increases, the inter symbol interference channel length m increases and the circuit scale of the conventional maximum decoder increases to a greater extent. For example, the circuit scale increases to a great extent four times as large when the inter symbol interference channel length changes from 2 bits (one front and rear bit) to 4 bits (two front and rear bits). For this reason, it is very difficult to provide a sufficient channel length.

## SUMMARY OF THE INVENTION

A main object of the invention is to provide a maximum likelihood decoder which can reduce the circuit scale to a great extent with the decoding accuracy being maintained without sacrifice.

There is provided, in accordance with the invention, a maximum likelihood decoder utilizing a Viterbi algorithm for keeping a digital signal recording and/or reproducing system from inter symbol interference. The maximum likelihood decoder has substitute states substituted for a plurality of states where the probability that inter symbol interference occurs is small or substitute transition paths substituted for a plurality of transition paths where the probability that inter symbol interference occurs.

## BRIEF DESCRIPTION OF THE DRAWINGS

This invention will be described in greater detail by reference to the following description taken in connection with the accompanying drawings, in which:

Fig. 1 is a schematic block diagram showing one embodiment of a maximum likelihood decoder made in accordance with the invention;

Fig. 2 is a Trellis diagram for use in designing the maximum likelihood decoder of the invention;

Fig. 3 is a schematic block diagram showing a conventional maximum likelihood decoder;

Fig. 4 is a Trellis diagram for use in designing the conventional maximum likelihood decoder.

Fig. 5 shows simulated results for the conventional maximum likelihood decoder.

## DETAILED DESCRIPTION OF THE INVENTION

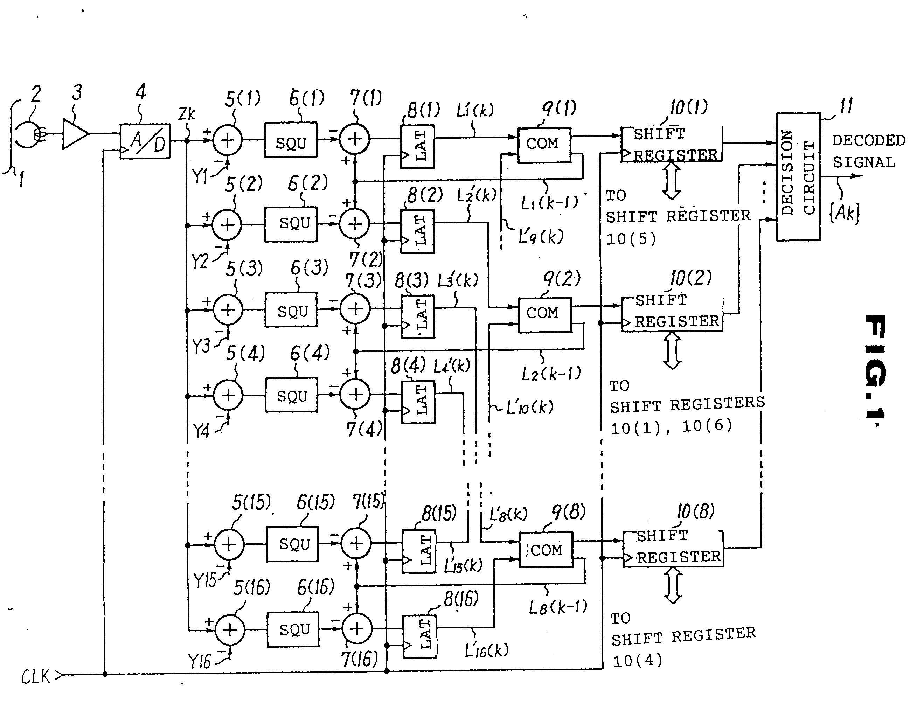

Referring to Fig. 1, there is shown one embodiment of a maximum likelihood decoder made in accordance with the invention. The digital data recorded on a magnetic recording medium 1 is reproduced by a head 2. The reproduced signal is amplified by a head amplifier 3 and sampled at uniform intervals of time corresponding to the predetermined repetitive period of clock (CLK) pulses.

In this embodiment where the inter symbol interference from the adjacent bit is two bits for each of the front and rear portions of the detection bit AK, that is, the channel length of the inter symbol interference is 4 bits, the number of the states is reduced from 16 to 8 and the number of the transition paths is reduced from 32 to 16. These reductions is made by setting the alternative state and the alternative transition path with which a plurality of conventional states and transition paths are replaced according to the degree of the inter symbol interference.

The subtractors 5 (1-16), the squaring circuits 6 (1-16), and the subtractors 7 (1-16) calculate sixteen proposed metrics $L'1(k)$ to $L'16(k)$ corresponding to the transition paths. The proposed metrics are stored in the respective latches 8 (1-16). Assuming now that Y1 to Y16 are the estimated sample values for the respective transition paths, and K1(k-1) to K8(k-1) are the metrics for the respective states at the last time (k-1), the proposed metrics $L'1(k)$ to $L'16(k)$ are given as

$$L'1(k) = L1(k-1) - (Zk - Y1)^2$$
$$L'2(k) = L1(k-1) - (Zk - Y2)^2$$
$$L'3(k) = L2(k-1) - (Zk - Y3)^2$$
$$\vdots$$
$$\vdots$$
$$L'16(k) = L8(k-1) - (Zk - Y16)^2$$

The comparator 9(1) compares the proposed metrics L'1(k) and L'9(k) for the two transition paths which joins to the state at time k and operates as follows:

(A) Where L'1(k) > L'9(k),

(A-1) the comparator 9(1) selects the proposed metric L'1(k) as the metric L1(k) and produces it to the subtractors 7(1) and 7(2) at time (k+1),

(A-2) the shift register 10(1) retains its content as it is, and

(A-3) the comparator 9(1) loads a signal "0" serially to the shift register 10(1). At the same time, the shift register 10(1) performs a FIFO (first-in-first-out) operation to provide a decoding result to the decision circuit 11.

(B) Where L'1(k) < L'9(k),

(B-1) the comparator 9(1) selects the proposed metric L'9(k) as the metric L1(k) and produces it to the subtractors 7(1) and 7(2) at time (k+1),

(B-2) a parallel load of the content of the shift register 10(5) to the shift register 10(1), and

(B-3) the comparator 9(1) performs a serial load of a signal "0" to the shift register 10(1). At the same time, the shift register 10(1) performs a FIFO (first-in-first-out) operation to provide a decoding result to the decision circuit 11.

For the other comparators 9(2-8), similar operations are performed according to the Trellis diagram.

In this embodiment where the channel length is set at 4 bits, since an alternative state is provided for a plurality of states to reduce the number of the states required in the conventional apparatus and an alternative path is provided for a plurality of transition paths to reduce the number of the transition paths required in the conventional apparatus, it is possible to reduce the circuit scale to one-half of the conventional apparatus while maintaining substantially the same decoding accuracy as obtained in the conventional apparatus.

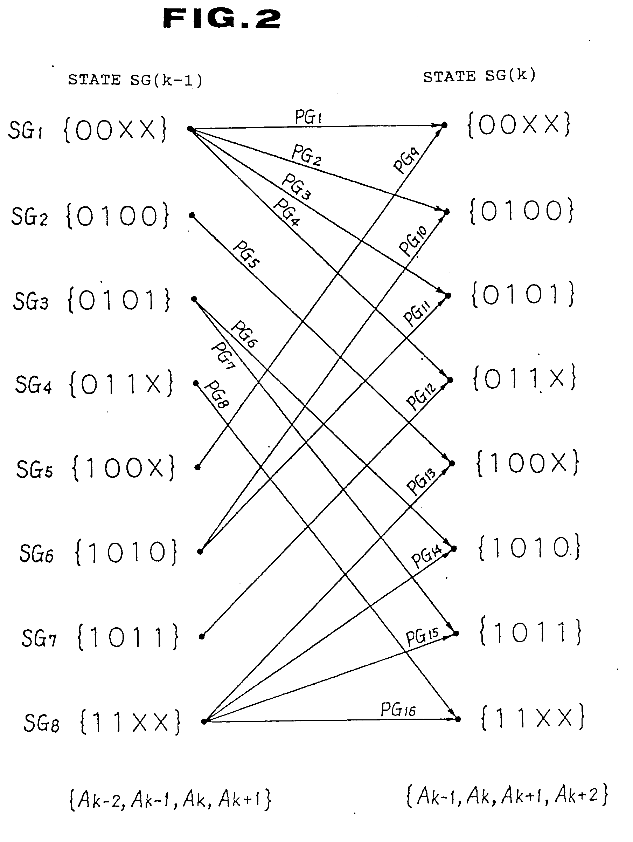

Fig. 2 is a Trellis diagram showing the transition paths in this embodiment where the channel length of the inter symbol interference is 4 bits. Description will be made to the Trellis diagram of Fig. 2 in connection with the Trellis diagram of Fig. 4 related to the conventional decoder. An attention should be drawn to the bit patterns of Fig. 4 changed when states Si(k-1) (where i = 1-16) established at time (k-1) change to respective states Si(k) at time k. For example, for the state transition path P6, the state S3(k-1){0010} changes to the state S6(k){0101}. The bit pattern has bits inverted repetitively. Since the bit inversion means an inversion of magnetization in the magnetic recording, it may be considered that the degree of the inter symbol interference resulting from a non-linear distortion is great for such a bit pattern, that is, for the states S5, S6, S11 and S12. When the number of the bit inversions is small, a plurality of states is replaced with or grouped into a single alternate state so that the 16 states required in the conventional apparatus are reduced into 8 alternate stages SG1 to SG8. That is, the states S1 to S4 are replaced by a substitute state SG1, the state S5 is replaced by a substitute state SG2, the state S6 is replaced by a substitute state SG3, the states S7 and S8 are replaced by a substitute state SG4, the states S9 and S16 are replaced by a substitute state SG5, the state S11 is replaced by a substitute state SG6, the state S12 is replaced by a substitute state SG7, and the states S13 to S16 are replaced by a substitute state SG8. The state S5, S6, S11 or S12 where a great degree of inter symbol interference is estimated is not grouped and replaced by a substitute state SG2, SG3, SG6 or SG7. That is, these four substitute states are the same as the states in the conventional apparatus.

For the substitute states SG1 to SG8, the conventional transition paths P1 to P32 are reduced to sixteen substitute transition paths PG1 to PG16, as shown in Fig. 2. The transition paths P5, P6, P27 or P28 are replaced by substitute transition paths PG9, PG10, PG14 or PG15. That is, these four substitute transition paths are the same as in the conventional apparatus.

As described above, according to the invention, it is possible to reduce the number of the states and the number of the transition paths by replacing a plurality of states where the probability of occurrence of inter symbol interference is small with a single substitute state and replacing a plurality of transition paths with a single substitute transition path. In order to confirm that the decoder of the invention can provide a high decoding

EP 0 521 744 A2

accuracy substantially the same as obtained in the conventional decoder of Fig. 3 even when the numbers of the states and transition paths are reduced, the estimated sample values Y1 to Y32 (Fig. 3)are simulated.

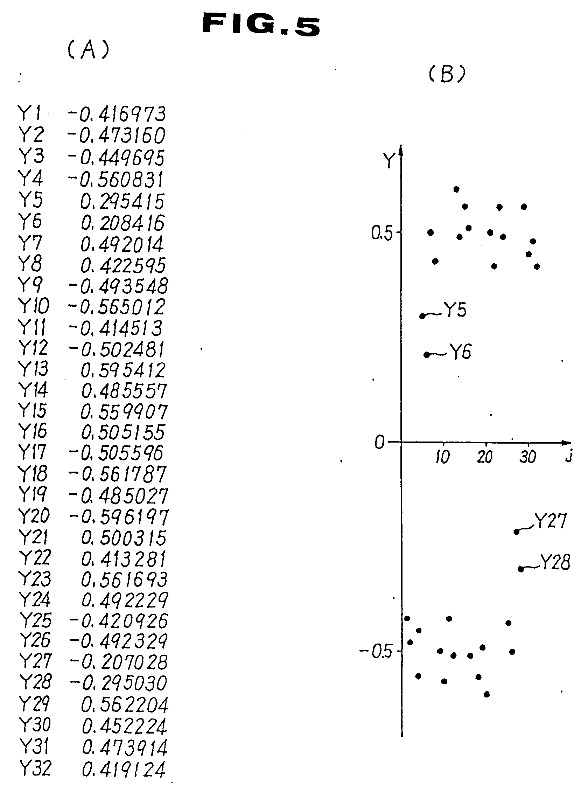

Fig. 5(A) is a list of the results of simulation of the estimated sample values Y1 to Y32 where the logic "1" level corresponds to 0.5 and the logic "0 " level corresponds to -0.5. Fig. 5(B) is a graph having simulation results plotted thereon. The estimated sample value Yj (were j = 1 to 32) is an estimated value for the sample Zk obtained when a state changes through a transition path Pj to a certain state at time k. The estimated sample value yj includes the inter symbol interference and it is obtained by analyzing the characteristics of the recording and/or reproducing system. The deviation of the estimated sample value Yj with respect to 0.5 or -0.5 is dependent on the degree of the inter symbol interference and it can be used as an index when plural states and transition paths are grouped.

As can be seen from Fig. 5(B), the estimated sample values Y5, Y6, Y27 and Y28 of the respective transition paths P5, P6, P27 and P28 have singular values because of great degrees of inter symbol interference. As described previously, these transition paths P5, P6, P27 and P28 are not grouped and retained as independent substitute transition paths PG2, PG3, PG6 and PG7 (as in conventional decoder). For this reason, a high decoding accuracy can be obtained even when the Trellis diagram of Fig. 4 is simplified as shown in Fig. 2.

The maximum likelihood decoder of Fig. 1 is made according to the Trellis diagram of Fig. 2(A). The arrangement of this embodiment utilizes a number of components previously described in connection with Fig. 3. Description will be made only to the difference between them to avoid duplicity. The main differences are as follows:

(1) The number of the subtractors 5 and 7, the square circuits 6 and the latches 8 is reduced from 32 (conventional decoder) to 16 (invention).

(2) The number of the comparators 9 and the shift registers 10 is reduced from 16 (conventional decoder) to 8 (invention).

(3) The estimated sample values Y1 to Y16 provided to the respective subtractors 5 are provided for the substitute transition paths PG1 to PG16 in place of transition paths.

(4) The mutual connection lines between the shift registers 10(1) to 10(8), that is, the mutual connection lines permitting the parallel load of the content of the shift register when the surviving path is decided are different from those of the conventional decoder and they are made according to the Trellis diagram of Fig. 2.

(5) The arrangement of the invention, which utilizes a Viterbi algorithm to make maximum likelihood decoding with the channel length of the inter symbol interference being 4 bits, has a circuit scale substantially the same as the conventional decoder having a 3-bit channel length.

Although the invention has been described in connection with a maximum likelihood decoder having a 4-bit inter symbol interference channel length, it is to be understood that it is not limited to this inter symbol interference channel length.

The invention is effective for maximum likelihood decoding where the inter symbol interference channel length is 3 or more bits. That is, the number of the transition paths is reduced from 16 (conventional decoder) to 12 when the inter symbol interference channel length is 3 bits and from 32 (conventional decoder) to 16 when the inter symbol interference channel length is 4 bits. The number of the transition paths decreases as the bit number increases. According to the invention, it is possible to reduce the circuit scale to a remarkable extent with the decoding accuracy being maintained without significant sacrifice for maximum likelihood decoders having an inter symbol interference channel length of 3 or more bits. This is effective to provide an easy encounter for increases in the length of the channel of the inter symbol interference resulting from high density digital signal recording.

## Claims

1. A maximum likelihood decoder utilizing a Viterbi algorithm for keeping a digital signal recording and/or reproducing system (1,2) from inter symbol interference, characterized in that the maximum likelihood decoder has substitute states substituted for a plurality of states where the probability that inter symbol interference occurs is small or subtitute transition paths substituted for a plurality of transition paths.

2. The maximum likelihood decoder according to claim 1, further comprising:
   original states for a plurality of states where the probability that inter symbol interference occurs is great or
   original transition paths for a plurality of transition paths.

5

3. The maximum likelihood decoder according to claim 2, wherein said substitute states are changed from a plurality of original states where the probability that inter symbol interference occurs is small.

4. The maximum likelihood decoder according to claim 3, wherein the inter symbol interference occurrences are caused by an inversion of magnetization in magnetic recording.

5. The maximum likelihood decoder according to claim 4, wherein said maximum likelihood decoder has an inter symbol interference channel length of 3 or more bits.

6. The maximum likelihood decoder according to claim 1 or claim 2, wherein said substitute states or substitute transition paths are grouped by the estimated sample values.

# FIG.1·

# FIG.2

STATE SG(k-1)                                    STATE SG(k)

SG₁ {OOXX}                                        {OOXX}

SG₂ {O1OO}                                        {O1OO}

SG₃ {O1O1}                                        {O1O1}

SG₄ {O11X}                                        {O11X}

SG₅ {1OOX}                                        {1OOX}

SG₆ {1O1O}                                        {1O1O}

SG₇ {1O11}                                        {1O11}

SG₈ {11XX}                                        {11XX}

$\{A_{k-2}, A_{k-1}, A_k, A_{k+1}\}$          $\{A_{k-1}, A_k, A_{k+1}, A_{k+2}\}$

FIG.3

EP 0 521 744 A2

# FIG.4

STATE Si(k-1)                                    STATE Si(k)

$S_1$ {0000}                    $P_1$                    {0000} $S_1$
                                $P_2$
$S_2$ {0001}                    $P_{17}$                 {0001} $S_2$
                                $P_3$
$S_3$ {0010}                    $P_4$    $P_{18}$         {0010} $S_3$
                                $P_5$
$S_4$ {0011}                    $P_6$    $P_{19}$         {0011} $S_4$
                                         $P_{20}$
$S_5$ {0100}                    $P_7$                     {0100} $S_5$
                                         $P_{21}$
$S_6$ {0101}                                             {0101} $S_6$

$S_7$ {0110}                                             {0110} $S_7$

$S_8$ {0111}                                             {0111} $S_8$

$S_9$ {1000}                                             {1000} $S_9$

$S_{10}$ {1001}                                          {1001} $S_{10}$
                                $P_{15}$
$S_{11}$ {1010}                 $P_{16}$                  {1010} $S_{11}$

$S_{12}$ {1011}                                          {1011} $S_{12}$

$S_{13}$ {1100}                                          {1100} $S_{13}$

$S_{14}$ {1101}                                          {1101} $S_{14}$

$S_{15}$ {1110}                 $P_{31}$                  {1110} $S_{15}$

$S_{16}$ {1111}                 $P_{32}$                  {1111} $S_{16}$


{$A_{k-2}, A_{k-1}, A_k, A_{k+1}$}              {$A_{k-1}, A_k, A_{k+1}, A_{k+2}$}

10

# FIG.5

(A)

:

Y1  -0.416973
Y2  -0.473160
Y3  -0.449695
Y4  -0.560831
Y5   0.295415
Y6   0.208416
Y7   0.492014
Y8   0.422595
Y9  -0.493548
Y10 -0.565012
Y11 -0.414513
Y12 -0.502481
Y13  0.595412
Y14  0.485557
Y15  0.559907
Y16  0.505155
Y17 -0.505596
Y18 -0.561787
Y19 -0.485027
Y20 -0.596197
Y21  0.500315
Y22  0.413281
Y23  0.561693
Y24  0.492229
Y25 -0.420926
Y26 -0.492329
Y27 -0.207028
Y28 -0.295030
Y29  0.562204
Y30  0.452224
Y31  0.473914
Y32  0.419124

(B)